# DEMANDE DE BREVET EUROPEEN

(11) **EP 0 607 465 A1**
(43) Date de publication de la demande: **27.07.1994**
(21) Numéro de dépôt: 92402499.5
(22) Date de dépôt: 11.09.1992
(51) Int. Cl.: G01R 1/22, G01R 15/02, H01F 40/06

(54) **Pince ampèremétrique comprenant des moyens d'actionnement perfectionnés**

(71) Demandeur: SOCIETE MARECHAUX DUBOST INSTRUMENTS S.A., F-78290 Croissy-sur-Seine (FR)
(72) Inventeur:
(74) Mandataire: Launier, André

(57) **Abrégé**

L'invention concerne une pince ampèremétrique comprenant un boîtier (2), deux branches (5, 10) dont au moins une branche dite mobile (10) est montée dans le boîtier de façon à pouvoir pivoter, par rapport à l'autre branche (5) montée fixe dans le boîtier, entre une position de fermeture dans laquelle les deux branches forment une boucle fermée et une position d'ouverture dans laquelle celles-ci forment une boucle ouverte, des moyens sensibles à un champ magnétique qui traverse lesdites branches (5, 10), et des moyens d'actionnement agencés pour contribuer au déplacement de la branche mobile (10) par rapport à la branche fixe (5).

Selon l'invention, lesdits moyens d'actionnement comprennent un ressort à lame (26) interposé entre le boîtier (2) et la branche mobile (10) de façon à rappeler celle-ci vers l'une des deux positions susdites, et des moyens de manoeuvre (20) agencés pour contribuer au déplacement de la branche mobile (10) vers l'autre desdites positions, à l'encontre du ressort à lame (26).

## Description

L'invention concerne une pince ampèremétrique comprenant un boîtier, deux branches dont au moins une branche dite mobile est montée dans le boîtier de façon à pouvoir pivoter, par rapport à l'autre branche montée fixe dans le boîtier, entre une position de fermeture dans laquelle les deux branches forment une boucle fermée et une position d'ouverture dans laquelle celles-ci forment une boucle ouverte, des moyens sensibles à un champ magnétique qui traverse lesdites branches, et des moyens d'actionnement agencés pour contribuer au déplacement de la branche mobile par rapport à la branche fixe.

Le but de l'invention est de proposer des moyens d'actionnement particulièrement simples de conception.

Selon l'invention, lesdits moyens d'actionnement comprennent un ressort à lame interposé entre le boîtier et la branche mobile de façon à rappeler celle-ci vers l'une des deux positions susdites, et des moyens de manoeuvre agencés pour contribuer au déplacement de la branche mobile vers l'autre desdites positions, à l'encontre du ressort à lame.

Avantageusement, le ressort à lame comprend deux ailes dont une est fixée sur ladite branche mobile et dont l'autre coulisse dans une fente pratiquée dans le boitier.

Avantageusement, le ressort à lame comprend deux ailes dont une est fixée sur le boîtier et dont l'autre prend appui sur la branche mobile.

Avantageusement, chaque branche présente deux extrémités agencées pour coopérer avec celles de l'autre branche, la branche mobile pivotant autour d'un axe situé au voisinage de l'une de ses extrémités.

Avantageusement, lesdits moyens de manoeuvre comprennent une patte prolongeant une extrémité de la branche mobile, la branche mobile pivotant autour d'un axe situé entre ladite extrémité et ladite patte.

Avantageusement, la pince comprend un bouton-poussoir monté dans le boîtier de façon à pouvoir coulisser et coopérant avec ladite patte.

Avantageusement, la pince comprend un support de pince attelé de façon démontable à la pince, ledit bouton-poussoir étant monté dans le support de pince.

D'autres détails et avantages de l'invention apparaîtront au cours de la description suivante de quelques formes de réalisation préférées mais non limitatives, en regard des dessins annexés, sur lesquels :
La figure 1 est une vue de face et en élévation d'une pince ampèremétrique selon une première forme de réalisation de l'invention, montée sur un support de pince ;
Les figures 2 et 3 sont des vues agrandies de la pince de la figure 1, représentant l'une la pince fermée, et l'autre la pince ouverte ;
Les figures 4 et 5 correspondent aux figures 2 et 3, dans une seconde forme de réalisation de l'invention.

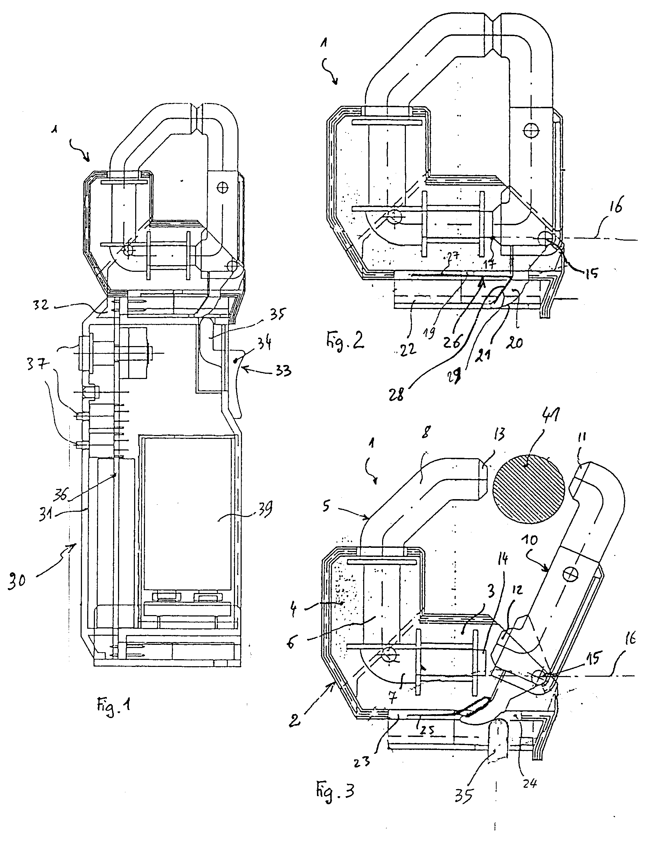

Sur les figures 1 à 3 est représentée une pince ampèremétrique 1 connue en elle-même et comprenant un boitier 2 présentant une forme générale de L définie par une portion de base 3 et une portion de tête 4. Une branche fixe 5 de la pince 1 est en forme générale de U présentant une base 6, une aile intérieure 7 et une aile extérieure 8, la base et l'aile intérieure 7 étant logées respectivement dans la portion de base 3 et la portion de tête 4 du boîtier 2 tandis que l'aile extérieure 8 fait saillie, à partir de la position de tête 4, à l'extérieur du boîtier 2.

Une branche mobile 10 de la pince 1 est de forme générale droite et présente deux extrémités 11, 12 agencées pour prendre appui sur deux extrémités 13, 14 de la branche fixe 5. Selon l'invention, elle est montée à pivotement, au voisinage de son extrémité 12, autour d'un axe 15 fixé à une extrémité de la portion de base 3 du boitier 2 et s'étendant perpendiculairement à un plan défini par les deux branches 5, 10.

Les branches 5, 10 de la pince, qui sont de section circulaire, présentent, à leurs extrémités 11 à 14, des surfaces planes destinées à être appliquées les unes sur les autres. L'axe 15 est situé sur une ligne 16 perpendiculaire aux surfaces planes des extrémités 12, 14 des branches et passant par un point 17 de contact entre ces surfaces planes, le plus éloigné des extrémités opposées 11, 13 des branches. Ainsi, les extrémités 12, 14 peuvent porter correctement l'une sur l'autre.

Les deux branches 5, 10 de la pince 1 sont réalisées en un matériau ferromagnétique. La branche fixe porte une bobine de fil conducteur sur sa base 6 et, soit une autre bobine sur son aile intérieure 7 si la pince doit être utilisée comme pince ampèremétrique inductive, soit une cellule à effet Hall si elle doit être utilisée comme pince ampèremétrique à effet Hall.

Au voisinage de l'extrémité 12 de la branche mobile 10 de la pince montée à pivotement, la branche porte une patte 20 s'étendant dans le plan défini généralement par les branches, disposée de façon inclinée par rapport à un axe longitudinal de la branche mobile 10 et saillant vers l'extérieur du boîtier, dans une direction opposée à l'axe 15. La patte 20 porte une surface bombée 21, opposée à une surface plane 29.

La portion de base 3 du boîtier 2 porte extérieurement un rail 22 de section en forme de T, s'étendant le long de cette portion.

Une paroi latérale 23 de la portion de base 3 du boîtier 2 présente un évidement 24 traversé par la patte 20, et une fente 25 s'étendant dans un plan de cette paroi et la divisant dans une épaisseur. Cette fente débouche dans l'évidement 24, en une région de celui-ci la plus éloignée de l'axe 15. Un ressort à lame 26, réalisé dans une feuille de métal, présente une forme de V comprenant une aile longue 27 et une aile courte 28. Une extrémité libre de l'aile longue 27 s'étend à l'intérieur de la fente 25, tandis que son aile courte 28 s'applique, lorsque la pince est au repos (figure 2), contre la surface plane 29 de la patte 20 et tend à faire pivoter la branche mobile 10 vers la branche fixe 5. Eventuellement, l'aile longue 27 peut être fixée dans la fente 25. Par ailleurs, la paroi latérale 23 de la portion de base 3 du boîtier 2 porte une butée 19 prolongeant cette paroi et faisant légèrement saillie dans l'évidement 24, à partir de la fente 25 et seulement sur une demi-épaisseur de paroi disposée à l'intérieur du boîtier 2 par rapport au ressort à lame 26. Toutefois, la butée 19 n'est pas disposée en face du ressort à lame 26 mais est décalée par rapport à lui.

Sur la figure 1 est représenté un support de pince ampèremétrique 30 comprenant un boîtier parallélépipédique 31 allongé portant, à une extrémité, une rainure 32 agencée pour recevoir à coulissement le rail 22 de la pince 1. Au voisinage de cette extrémité, est monté un bouton-poussoir 33 de façon à pouvoir coulisser perpendiculairement à la rainure 32 et le long du boîtier 31.

Le bouton-poussoir 33 présente une tête 34 située à l'extérieur du boitier 31, le long d'une paroi latérale de celui-ci, et un doigt 35 relié à la tête 34, arrondi à une extrémité libre. Le doigt 35 est disposé à l'intérieur du boîtier 31 et s'étend dans la direction de coulissement du bouton-poussoir 33 de façon que, lorsque la pince 1 est montée sur le support de pince 30, il fait face à la surface bombée 21 de la patte 20 de la pince. Dans une position du bouton-poussoir 33 la plus intérieure représentée sur la figure 1, l'extrémité libre de son doigt 35 est très voisin de la patte 20.

Le rail 22 et la rainure 32 comportent des moyens de contact électrique mutuel pour assurer une liaison électrique entre la pince 1 et le support de pince 30. Avantageusement, le support de pince 30 peut constituer une unité de traitement électronique de signaux provenant de la pince 1 et comprendre à cet effet un circuit imprimé 36, des boutons de réglage 37 et des moyens d'alimentation 39.

En utilisation, un opérateur, cherchant à mesurer l'intensité d'un courant traversant un conducteur 41 s étendant linéairement, dispose la pince 1 autour de celui-ci. Pour ce faire, il déplace manuellement le bouton-poussoir 33 de façon à pousser la patte 20 vers l'intérieur de la pince 1, ce qui a pour effet d'éloigner la branche mobile 10 de la branche fixe 5. Dans cette opération, le déplacement de la patte 20 produit deux effets : l'aile courte 28 du ressort à lame 26 est rabattue vers son aile longue 29, et les deux ailes sont rabattues ensemble à l'intérieur du boîtier 2 de la pince vers une position finale illustrée en figure 3. Dans cette position finale, une extrémité libre de la patte 20 vient buter contre la butée 19.

Une fois que l'opérateur a relâché le bouton-poussoir 33, le ressort à lame 26 ramène la branche mobile 10 dans sa position de repos et repousse le bouton-poussoir vers sa position la plus intérieure.

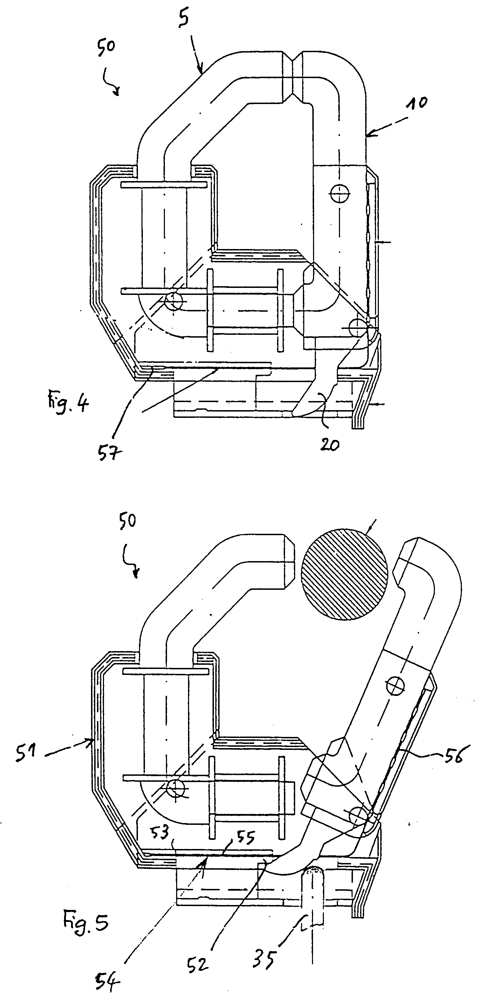

Les figures 4 et 5 sont relatives à une pince 50 constituant une variante de celle des figures 1 à 3 et portent, en ce qui concerne les mêmes éléments, des références identiques. Le boîtier 51 diffère du précédent en ce que la butée 52 portée par la paroi latérale 53 s'étend de part et d'autre du ressort à lame 54 et entoure celui-ci. Par ailleurs, le ressort à lame 54 a une forme de L présentant deux ailes 55, 56 dont une 55 montée dans la fente 57 de la paroi latérale 53 de façon à pouvoir coulisser, tandis que l'autre 56 s'étend le long d'une face de la branche mobile 10 la plus éloignée de la branche fixe 5 et est fixée sur cette face en plusieurs points répartis.

En outre, l'aile 55 du ressort à lame ne s'étend pas en face de la patte 20 de la branche mobile 10 mais est décalée par rapport à elle.

La longueur de l'aile 55 du ressort à lame 54 est telle que, lorsque la pince 50 est au repos, elle ne remplit pas complètement la fente 57 de manière à laisser un espace libre (figure 4). En revanche, lorsqu'un opérateur ouvre la pince, le pivotement de la branche 10 tend à repousser l'aile 55 davantage dans la fente 57 (figure 5), ce qui est rendu possible en raison de la présence de l'espace libre prévu. Lorsque l'opérateur relâche la pince 50, le ressort à lame 54 tend à revenir à sa forme première, c'est-à-dire à se refermer vers une forme dans laquelle ses ailes sont davantage rapprochées l'une de l'autre : on observe alors simultanément un déplacement de l'aile 55 vers l'extérieur de la fente 57 et un pivotement de l'aile 56 dans un sens anti-horaire (figure 5).

## Revendications

1. Pince ampèremétrique comprenant :
- un boîtier (2) ;
- deux branches (5, 10) dont au moins une branche dite mobile (10) est montée dans le boîtier de façon à pouvoir pivoter, par rapport à l'autre branche (5) montée fixe dans le boîtier, entre une position de fermeture dans laquelle les deux branches forment une boucle fermée et une position d'ouverture dans laquelle celles-ci forment une boucle ouverte ;
- des moyens sensibles à un champ magnétique qui traverse lesdites branches (5, 10) ; et
- des moyens d'actionnement agencés pour contribuer au déplacement de la branche mobile (10) par rapport à la branche fixe (5) ; caractérisée en ce que lesdits moyens d'actionnement comprennent :
- un ressort à lame (26) interposé entre le boîtier (2) et la branche mobile (10) de façon à rappeler celle-ci vers l'une des deux positions susdites ; et
- des moyens de manoeuvre (20) agencés pour contribuer au déplacement de la branche mobile (10) vers l'autre desdites positions, à l'encontre du ressort à lame (26).

2. Pince selon la revendication 1, dans laquelle le ressort à lame (50) comprend deux ailes (55, 56) dont une (56) est fixée sur ladite branche mobile (10) et dont l'autre (55) coulisse dans une fente (57) pratiquée dans le boîtier (2).

3. Pince selon la revendication 1, dans laquelle le ressort à lame (26) comprend deux ailes (27, 28) dont une (27) est fixée sur le boîtier (2) et dont l'autre (28) prend appui sur la branche mobile (10).

4. Pince selon l'une quelconque des revendications précédentes, dans laquelle chaque branche (5, 10) présente deux extrémités (13, 14) agencées pour coopérer avec celles (11, 12) de l'autre branche, la branche mobile (10) pivotant autour d'un axe (15) situé au voisinage de l'une (12) de ses extrémités.

5. Pince selon l'une quelconque des revendications précédentes, dans laquelle lesdits moyens de manoeuvre comprennent une patte (20) prolongeant une extrémité (12) de la branche mobile (10), la branche mobile (10) pivotant autour d'un axe (15) situé entre ladite extrémité (12) et ladite patte (20).

6. Pince selon la revendication 5, qui comprend un bouton-poussoir (33) monté dans le boîtier (2) de façon à pouvoir coulisser et coopérant avec ladite patte (20).

7. Pince selon la revendication 6, qui comprend un support de pince (30) attelé de façon démontable à la pince (1), ledit bouton-poussoir (33) étant monté dans le support de pince (30).
